# EUROPEAN PATENT APPLICATION

(11) **EP 4 391 758 A1**
(43) Date of publication of application: **26.06.2024**
(21) Application number: 23218235.2
(22) Date of filing: 19.12.2023
(51) Int. Cl.: H05K 7/20

(54) **REFRIGERANT CIRCUIT AND COOLING SYSTEM FOR A VFD HEAT SINK**

(30) Priority: 20.12.2022 US 202263476263 P
(71) Applicant: Carrier Corporation, Palm Beach Gardens, FL 33418 (US)
(72) Inventor: MOHANTA, Lokanath, Syracuse, NY 13221 (US); BORISOV, Konstantin, Palm Beach Gardens, FL 33418 (US); JOARDAR, Arindom, Syracuse, NY 13221 (US); AGIRMAN, Ismail, Palm Beach Gardens, FL 33418 (US)
(74) Representative: Dehns

(57) **Abstract**

A refrigerant circuit for a variable frequency drive (VFD) heat sink is disclosed. The refrigerant circuit comprises one or more channels machined in a predefined profile and positioned in thermal contact with a VFD. The channels are adapted to allow the flow of a cooling fluid therethrough to facilitate the dissipation of heat generated by the VFD. The channels are machined in the predefined profile such that each of the machined flow path comprises a predefined number of turns or a predefined number of passes.

## Description

This patent application claims the benefit of US Provisional Patent Application No. 63/476,263, filed on Dec 20, 2022, which is incorporated by reference herein in its entirety.

This invention relates to the field of cooling systems, and more particularly, a refrigerant circuit and a cooling system for high power and compact heat sink associated with a variable frequency drive and/or electronic devices.

Compressors of a chiller system are generally configured with a heat sink and two-phased cooled variable frequency drive (VFD) that enable the chiller system to attain high efficiency at part load conditions and provide uniform temperature distribution. However, the distribution of the two-phase flow and achieving a high heat dissipation rate in a high power VFD while keeping the heat sink design compact and keeping the pressure drop low are very challenging, which has not been achieved in the existing systems. There is therefore a need to enable efficient distribution of the two-phase flow and achieve a high heat dissipation rate in a high power VFD while keeping the heat sink design compact and keeping the pressure drop low.

According to a first aspect of the invention, there is provided a refrigerant circuit for a variable frequency drive (VFD) heat sink. The refrigerant circuit comprises one or more channels machined in a predefined profile with one or more passes and positioned in thermal contact with one or more heat generating components associated with a VFD, wherein the channels are adapted to allow flow of a cooling fluid therethrough to facilitate dissipation of heat generated by the VFD.

Optionally, the one or more channels extend over one or more heat dissipating zones of the heat sink, wherein the one or more heat dissipating zones are at an electronic and/or electrical mount area of the one or more heat generating components associated with the VFD.

Optionally, the refrigeration circuit comprises an inlet conduit fluidically connected to a first end of the one or more channels, wherein the inlet conduit is configured to receive and supply the cooling fluid to the one or more channels, such that the cooling fluid while flowing through the one or more channels absorbs the heat dissipated by the VFD, and an outlet conduit fluidically connected to a second end of the one or more channels, wherein the outlet conduit is configured to enable outflow of the heat-absorbed cooling fluid from the one or more channels.

Optionally, the inlet conduit and the outlet conduit are configured parallelly at two opposite ends of the heat sink, wherein each of the channels having the predefined profile extends between the inlet conduit and the outlet conduit.

Optionally, the inlet conduit and the outlet conduit are fluidically configured with a refrigerant line associated with a refrigeration system that enables controlled flow of the cooling fluid through the inlet conduit, the one or more channels, and the outlet conduit.

Optionally, the VFD is associated with a compressor of the refrigeration system.

Optionally, the one or more channels comprises a flow path having a predefined cross-sectional shape machined in the predefined profile such that each of the machined channels comprises a predefined number of turns or a predefined number of passes.

According to a second aspect of the invention, there is provided a cooling system for a VFD. The cooling system comprises a heat sink in thermal contact with one or more components of the VFD, and a refrigerant circuit machined in the heat sink such that the refrigerant circuit extends over and remains in thermal contact with the one or more components of the VFD, wherein the refrigerant circuit comprises one or more channels having a predefined profile and in thermal contact with the corresponding components of the VFD.

Optionally, the refrigerant circuit comprises an inlet conduit fluidically connected to a first end of the one or more channels of the refrigerant circuit, wherein the inlet conduit is configured to receive and supply the cooling fluid to the one or more channels, such that the cooling fluid while flowing through the one or more channels absorbs the heat dissipated by the VFD, and an outlet conduit fluidically connected to a second end of the one or more channels of the corresponding refrigerant circuit, wherein the outlet conduit is configured to enable outflow of the heat-absorbed cooling fluid from the one or more channels.

Optionally, the inlet conduit and the outlet conduit associated with the refrigerant circuit are fluidically connected to a refrigerant line associated with a refrigeration system that is configured to enable controlled flow of the cooling fluid through the refrigerant circuit.

Optionally, the cooling system comprises a controller in communication with the refrigeration system, wherein the controller is configured to monitor temperature of the heat sink and/or the VFD, and enable the refrigeration system to facilitate a controlled flow of the cooling fluid through the refrigeration circuit of the heat sink to keep the heat sink or the VFD at a predefined temperature.

Optionally, the one or more channels comprises a flowpath having a predefined cross-sectional shape being machined in the predefined profile such that each of the machined channels comprises a predefined number of turns or a predefined number of passes.

Optionally, the one or more channels extend over one or more heat dissipating zones of the VFD, wherein the one or more heat dissipating zones are at an electronic and/or electrical mount area of the one or more components associated with the VFD.

According to a third aspect of the invention, there is provided a cooling system for a heat dissipating device, the cooling system comprising: a heat sink in thermal contact with one or more components of the device; and a refrigerant circuit machined in the heat sink such that the refrigerant circuit extends over and remains in thermal contact with the one or more components of the device, wherein the refrigerant circuit comprises one or more channels machined in a predefined profile and in thermal contact with the corresponding components of the device.

Optionally, the refrigerant circuit comprises an inlet conduit fluidically connected to a first end of the one or more channels of the refrigerant circuit, wherein the inlet conduit is configured to receive and supply the cooling fluid to the one or more channels, such that the cooling fluid while flowing through the one or more channels absorbs the heat dissipated by the device, and an outlet conduit fluidically connected to a second end of the one or more channels of the corresponding refrigerant circuit, wherein the outlet conduit is configured to enable outflow of the heat-absorbed cooling fluid from the one or more channels.

Optionally, the inlet conduit and the outlet conduit of the refrigeration circuit are configured parallelly at two opposite ends of the corresponding heat sink, wherein each of the channels having the predefined profile extends between the two opposite ends of the heat sink.

Optionally, the inlet conduit and the outlet conduit associated with the refrigerant circuit are fluidically configured with a refrigerant line associated with a refrigeration system that enables controlled flow of the cooling fluid through the refrigerant circuit.

Optionally, the cooling system comprises a controller in communication with the refrigeration system, wherein the controller is configured to monitor temperature of the heat sink and/or the device, and enable the refrigeration system to facilitate a controlled flow of the cooling fluid through the refrigeration circuit of the heat sink to keep the heat sink or the device at a predefined temperature.

Optionally, the one or more channels comprise a flow path having a predefined cross-sectional shape being machined in the predefined profile such that each of the machined channels comprises a predefined number of turns or a predefined number of passes.

Optionally, the device comprises one or more of a semiconductor device, a power-electronic device, an electrical circuit, and a printed circuit board.

The first aspect of the invention may comprise any of the features recited herein with reference to the second and/or third aspect(s) of the invention. The second aspect of the invention may comprise any of the features recited herein with reference to the first and/or third aspect(s) of the invention. The third aspect of the invention may comprise any of the features recited herein with reference to the first and/or second aspect(s) of the invention.

The foregoing summary is illustrative only and is not intended to be in any way limiting. In addition to the illustrative aspects, embodiments, and features described above, further aspects, embodiments, features, and techniques of the invention will become more apparent from the following description taken in conjunction with the drawings.

The accompanying drawings are included by way of example only and to provide a further understanding of the subject disclosure of this invention and are incorporated in and constitute a part of this specification. The drawings illustrate exemplary embodiments of the subject disclosure and, together with the description, serve to explain the principles of the subject disclosure.

In the drawings, similar components and/or features may have the same reference label. Further, various components of the same type may be distinguished by following the reference label with a second label that distinguishes among the similar components. If only the first reference label is used in the specification, the description is applicable to any one of the similar components having the same first reference label irrespective of the second reference label.
FIG. 1A is a schematic diagram illustrating an exemplary embodiment of the refrigerant circuit in accordance with one or more embodiments of the disclosure.
FIGs. 1B and 1C are schematic diagrams illustrating another exemplary embodiment of the refrigerant circuit having turns in accordance with one or more embodiments of the disclosure.
FIG. 1D is a schematic diagram illustrating yet another exemplary embodiment of the refrigerant circuit having passes in accordance with one or more embodiments of the disclosure.
FIGs. 1E and 1F are exemplary views of a heat sink body having grooves forming the channels as depicted in the refrigerant circuit of FIG. 1A in accordance with one or more embodiments of the disclosure.
FIG. 2 is a schematic diagram illustrating a top view of the refrigerant circuit of FIG. 1C configured over a VFD or device having electronics components or heat dissipating zones being distributed at different locations of the heat sink in accordance with one or more embodiments of the disclosure.
FIG. 3 is a block diagram of a cooling system for a VFD and/or device in accordance with one or more embodiments of the disclosure.
FIG. 4 is a simulated graph depicting the variation of the surface temperature of the heat sink with respect to the length of the channel for different configurations of the refrigerant circuit.
FIG. 5 is a simulated graph depicting the variation of differential pressure with respect to a flow rate of fluid in different configurations of the refrigerant circuit.

The following is a detailed description of embodiments of the disclosure depicted in the accompanying drawings. The embodiments are in such detail as to clearly communicate the disclosure. However, the amount of detail offered is not intended to limit the anticipated variations of embodiments; on the contrary, the intention is to cover all modifications, equivalents, and alternatives falling within the spirit and scope of the subject disclosure as defined by the appended claims.

Various terms are used herein. To the extent a term used in a claim is not defined below, it should be given the broadest definition persons in the pertinent art have given that term as reflected in printed publications and issued patents at the time of filing.

In the specification, reference may be made to the spatial relationships between various components and to the spatial orientation of various aspects of components as the devices are depicted in the attached drawings. However, as will be recognized by those skilled in the art after a complete reading of the subject disclosure, the components of this invention. described herein may be positioned in any desired orientation. Thus, the use of terms such as "above," "below," "upper," "lower," "first", "second" or other like terms to describe a spatial relationship between various components or to describe the spatial orientation of aspects of such components should be understood to describe a relative relationship between the components or a spatial orientation of aspects of such components, respectively, as the conduits, inlet conduit, outlet conduit, heat sink, and refrigeration line, described herein may be oriented in any desired direction.

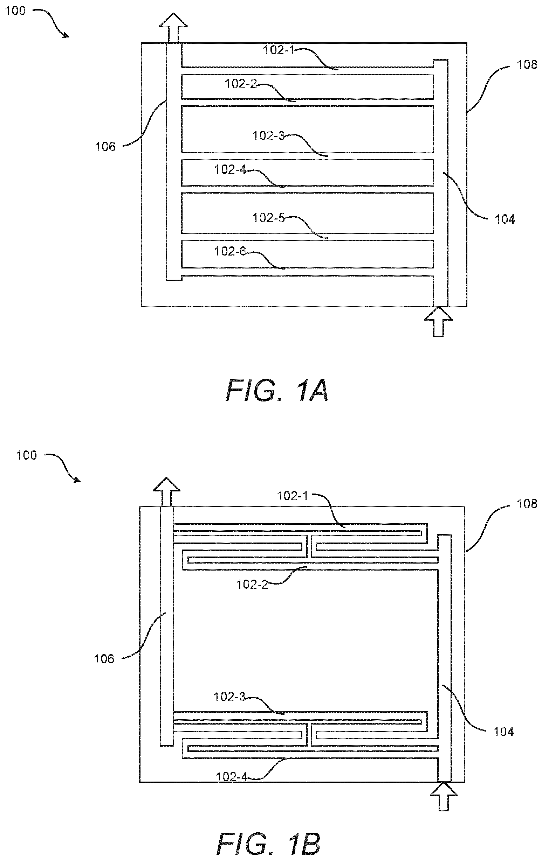

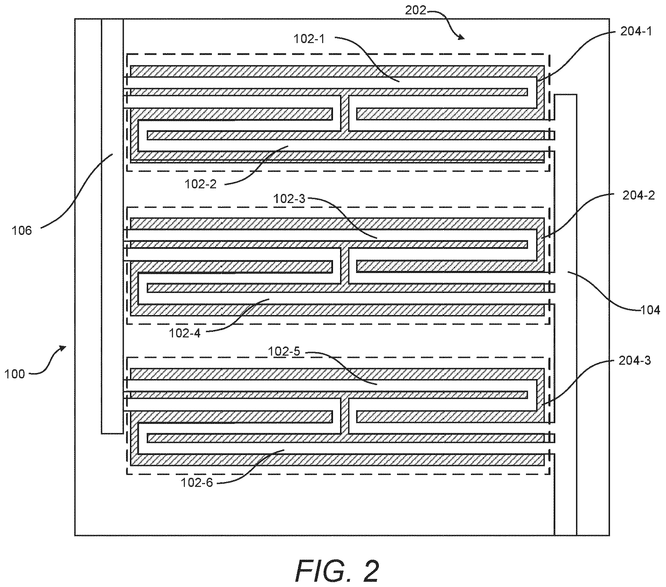

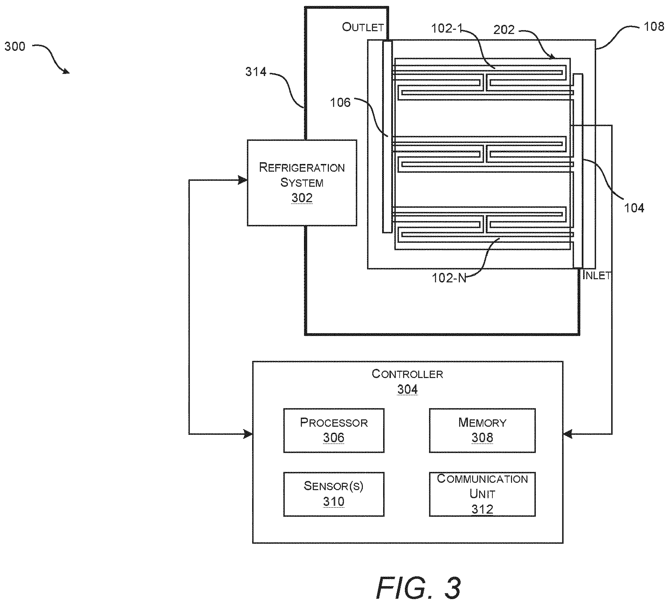

Referring to FIG. 1A to 2, exemplary embodiments of a refrigerant circuit 100 for a variable frequency drive (VFD) and/or heat dissipating devices (collectively designated as 202 in FIGs. 2 and 3, herein) are disclosed. The device/VFD 202 may include one or more heat dissipating components 204-1 to 204-3 (collectively referred to as heat dissipating components 204, herein) and other non-heat dissipating components. The refrigerant circuit 100 is kept in thermal contact with the heat dissipating components 204 of the VFD/device 202 and the non-heat dissipating components remains without the refrigerant circuit 100. In an exemplary embodiment, the device 202 can be one or more of a semiconductor device, a power-electronic device, an electrical circuit, a printed circuit board, or other high-power devices, and all such embodiments are well within the scope of this invention. The refrigerant circuit 100 includes one or more channels (102-1 to 102-6) collectively referred to as channels 102, herein) of a predefined profile and a predefined length, which are machined in a predefined profile such that each of the machined channels 102 includes a predefined number of turns or a predefined number of passes.

The refrigerant circuit 100 further includes a longitudinal inlet conduit 104 and a longitudinal outlet conduit 106 that extend parallel on two opposite ends of the device or VFD 202. Further, a first end of all the channels 102 is fluidically connected to the inlet conduit 104 and a second end of all the channels 102 is fluidically connected to the outlet conduit 106, such that the channels 102 extend between the inlet conduit 104 and the outlet conduit 106, thereby forming a heat sink 108 having one or more channels 102 with a predefined number of turns or a predefined number of passes. This increases the surface area of the refrigerant circuit 100 while keeping the refrigerant circuit 100 and the associated heat sink 108 compact and with minimal pressure drop.

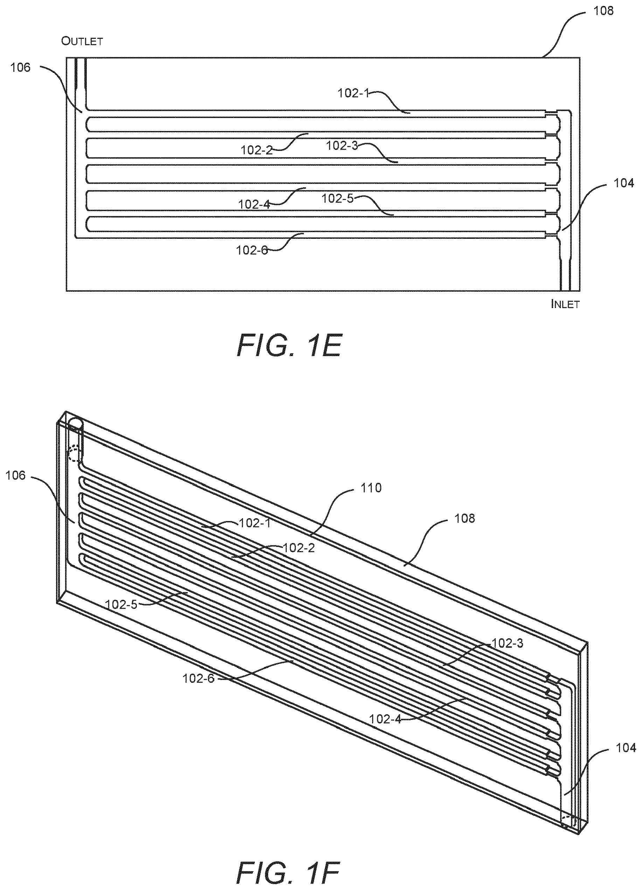

As illustrated in FIG. 1F, a body of the heat sink (also designated as 108, herein) is machined to form grooves having a profile corresponding to the profile of the refrigerant circuit 100, such that upon fixing a cover 110 over the body 108, the channels 102, the inlet conduit 104 and outlet conduit 106 of the refrigerant circuit 100 are formed in the heat sink 108. The channels 102 forms a flow path having a predefined cross-section shape including but not limited to circular, rectangular, square, and oval. The body 108 and cover 110 of the heat sink are made of thermally conductive material, which is positioned in thermal contact, either on one side or both sides, with the surface of the VFD or the device 202. The channels 102 are adapted to allow the flow of a cooling fluid therethrough, which facilitates dissipation of heat from the surface of the device 202. The mounting areas for the heat dissipating components 204-1 to 204-3 on the heat sink 108 forms one or more heat zones 204-1 to 204-3 (also collectively designated 204, herein) of the heat sink 108. In one or more embodiments, the heat sink 108 is configured with the device/VFD 202 such that the channels 102 of the refrigerant circuit 100 or heat sink remains in thermal contact, either on one side or both sides, of the heat dissipating components 204 of the device/VFD 202 and the non-heat dissipating components remains without the refrigerant circuit 100. Accordingly, the flow of the cooling fluid through the channels 102 facilitates dissipation of heat from the mounting areas or heat zones 204 of the device/VFD 202.

The distance between the channels 102, length of the channel 102, and the number of turns or passes in the channels 102 can be selected based on the dimension and location of the one or more heat zones 204-1 to 204-3 of the heat sink 108, such that the channels 102 can efficiently cover the heat zones 204 of the heat sink 108, especially when the heat load is more and when the electronic or electrical components of the VFD or devices 202 are distributed so that the cooling fluid while flowing through the channels 102 can efficiently absorb the heat from the device or VFD 202. The heat dissipating zones 204 (marked with a hashed area in FIG. 2) are generally at the electronic and/or electrical mount area (also designated as 204, herein) associated with the heat sink 108.

In an embodiment, as shown in FIGs. 1A, 1E, and 1F, the channels 102-1 to 102-6 can extend perpendicularly from the inlet conduit 104 and the outlet conduit 106. The channels 102-1 to 102-6 extend parallel to each other and are separated by a predefined distance. The distance between the parallel channels 102-1 to 102-6 may be selected based on the dimension and heat zones 204-1 to 204-3 of the device 202, such that the cooling fluid while flowing through the channels 102-1 to 102-6 can efficiently absorb the heat from the device or VFD 202.

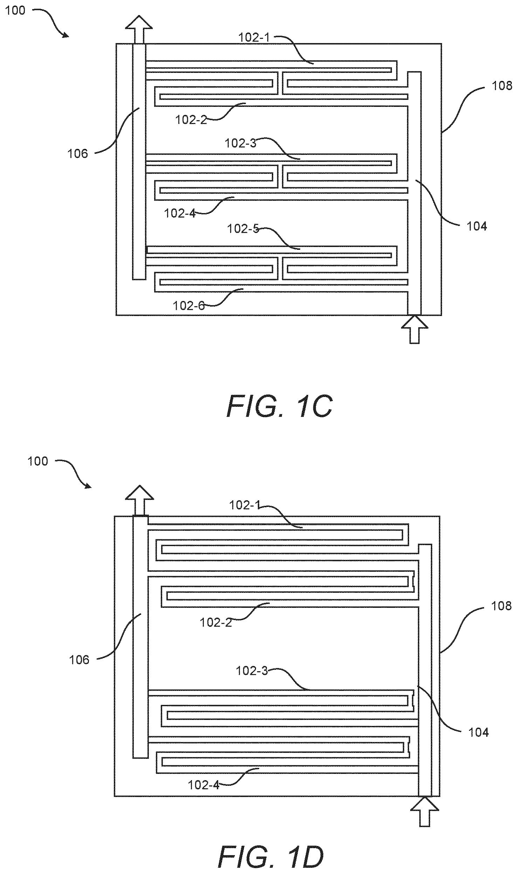

In an embodiment, as shown in FIGs. 1B and 1C, the channels 102 can be machined to form a predefined number of turns. For instance, the refrigerant circuit 100 can have six channels with two turns as shown in FIG. 1B or six channels with four turns as shown in FIG. 1C, however, refrigerant circuit 100 can have any number of channels with any number of turns based on the dimension and heat zones 204 of the heat sink 108 or device 202. Further, the channels 102 having turns can extend perpendicularly from the inlet conduit 104 and the outlet conduit 106 such that a predefined number of channels with a predefined number of turns are formed between the inlet conduit 104 and the outlet conduit 106. In some embodiment, as shown in FIGs. 1B and 1C, a first set of two channels 102-1, 102-2 having two turns can be kept close to each other. Further, another set of two closely placed channels 102-3, 102-4 can be separated by a predefined distance from the first set of channels 102-1, 102-2, depending upon the distribution of the heat dissipating units and heat zones 204. The length of channels 102, the distance between the channels 102 or two closely placed channels 102, and the number of turns in the channels 102 may be selected based on the dimension and heat zones 204 of the heat sink 108 or device 202, such that the channels can efficiently cover the heat zones of the device 202 and the cooling fluid while flowing through the channels 102 can efficiently absorb the heat from the device 202.

In an embodiment, as shown in FIG. 1D, the channels 102 can be machined on the heat sink body 108 to form a serpentine structure having a predefined number of passes in the channels 102. For instance, the refrigerant circuit 100 can have four channels with three passes as shown in FIG. 1D, however, the refrigerant circuit can have any number of channels 102 with any number of passes based on the dimension and heat zones 204 of the device 202. Further, the channels 102 having passes can extend perpendicularly from the inlet conduit 104 and the outlet conduit 106 such that a predefined number of channels (equal to the number of channels 102) with the predefined number of passes are formed between the inlet conduit 104 and the outlet conduit 106. In some embodiment, as shown in FIG. 1C, a first set of two channels 102-1, 102-2 having three passes can be kept close to each other. Further, another set of two closely placed channels 102-3, 102-4 can be separated by a predefined distance from the first set of channels 102-1, 102-2. Also, the channels 102 can be uniformly separated if the heating zones 204 are uniform. The length of the channels 102, the distance between the channels 102, and the number of passes may be selected based on the dimension and heat zones 204 and the amount of heat to be dissipated, such that the channels 102 can efficiently cover the heat zones 204 of the device 202 and the cooling fluid while flowing through the channels 102 can efficiently absorb the heat from the device 202.

Referring to FIGs. 2 and 3, exemplary embodiments of a cooling system 300 for a VFD and/or heat dissipating devices 202 are disclosed. The cooling system includes the heat sink 108 having one or more heat dissipating zones 204 in thermal contact with one or more components of the VFD or device 202. The refrigerant circuit 100 includes the channels 102 being machined in a predefined profile and thermal contact with the device 202. For instance, as shown in FIG. 2, the channels 102-1 and 102-2 of the refrigerant circuit 100 can be in thermal contact with heat zone 204-1, the channels 102-3 and 102-4 of the refrigerant circuit 100 can be in thermal contact with the heat zone 204-2, and the channels 102-1 and 102-2 of the refrigerant circuit 100 can be in thermal contact with heat zone 204-2 of the device 202. The inlet conduit 104 and outlet conduit 106 of the refrigerant circuits 100 can extend parallel on two opposite ends of the device 202 with the channel 102 extending between the inlet conduit 104 and outlet conduit 106 and in thermal contact with the heat zones 204.

The configuration of FIG. 2 is useful especially when the heat load is more and when the electronic or electrical components of the VFD or devices 202 are distributed and individual cooling is demanded so that the cooling fluid while flowing through the channels 102 can efficiently absorb the heat from the heat zones 204-1 to 204-N and can be controlled independently.

The cooling system 300 includes a refrigeration system 302 having a refrigeration line 314 fluidically coupled to the inlet conduit 104 and the outlet conduit 106 of the refrigerant circuits 100. The refrigeration system 302 is configured to enable the controlled flow of the cooling fluid through each of the refrigerant circuits 100. In some embodiments, the cooling system 300 or refrigerant circuit 100 is configured with a VFD 202 that is operatively coupled to a compressor (not shown) of the same refrigeration system 302. Herein, the cooling fluid of the refrigeration system 302 is circulated to the refrigerant circuit 100 of the VFD 202 to keep the VFD 202 or heat zones 204 at a predefined temperature. In other embodiments, the cooling system 300 or refrigerant circuit 100 for the VFD or devices 202 can also be fluidically connected to a separate refrigeration system.

In an operation, the refrigeration system 302 supplies the cooling fluid to the inlet conduit 104 of the refrigerant circuit 100. The cooling fluid then passes through each of the channels 102 and moves into the outlet conduit 106. The channels 102 made of thermally conductive material allow the cooling fluid to absorb heat from the heat dissipating units or heat zones 204 of the device 202 while flowing through the channels 102. In addition, the predefined profile of the channels 102 (as shown in FIGs. 1A to 1F) increases the heat transfer surface area channels 102 as well as increases the heat absorption time by the cooling fluid, thereby allowing efficient heat dissipation from the heat dissipating units 204. The heat-absorbed fluid then moves into the outlet conduit 104 and is supplied to the refrigeration system 302 via the refrigeration line 314 where the cooling fluid is again cooled and supplied back to the refrigerant circuit 100.

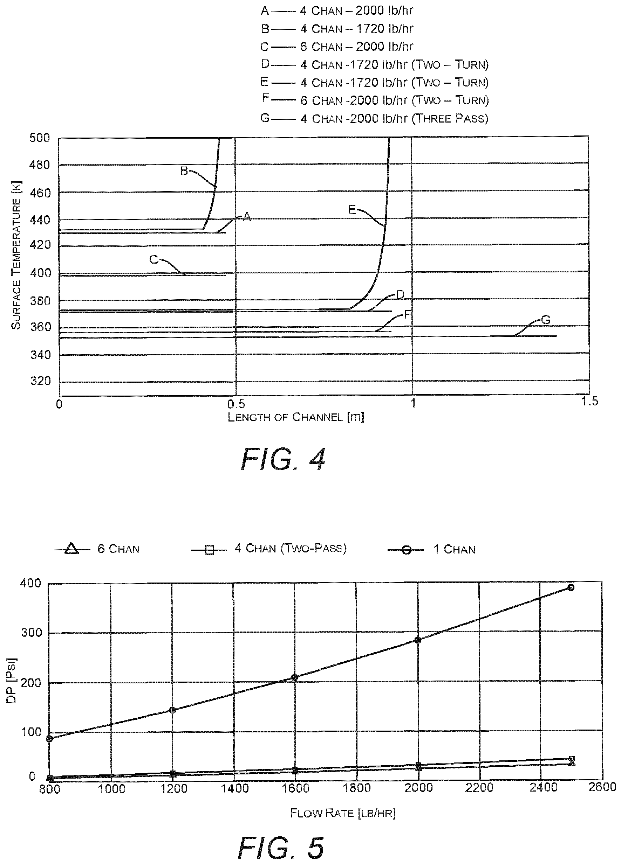

FIG. 4 is a simulated graph depicting the variation of the surface temperature of the heat sink with respect to the length of the channel for different configurations of the refrigerant circuit. FIG. 5 is a simulated graph depicting the variation of pressure drop with respect to flow rate of the cooling fluid in different configurations of the refrigerant circuit. As can be inferred from the model result of FIG. 4, the surface temperature of the heat sink reduces with an increase in the number of turns or passes in the channels of the refrigeration circuit. In addition, as can be inferred from the simulation result of FIG. 5, the pressure drop also reduces with an increase in the number of channels and passes in the refrigeration circuit compared to a single channel refrigeration circuit.

Referring back to FIG. 3, the cooling system 300 includes a controller 304 in communication with the refrigeration system 302. The controller 304 is configured with a set of thermal sensors 310 to monitor the temperature or temperature profile of the heat sinks 108 associated with the VFD or device 202. The controller 304 is further configured to enable the refrigeration system 302, based on the monitored temperature or as defined by a user, to facilitate a controlled flow of the cooling fluid through the refrigerant circuit 100 of the corresponding heat dissipating unit 204 to keep the heat dissipating unit 204 or the VFD/device 202 at a predefined temperature.

In an exemplary embodiment, the controller 304 includes a processor 306, a memory 308, heat sensors 310, and a communication unit 312 (wired or wireless media), being configured within a single housing that can be easily installed with the refrigeration system 302. The processor 306 is coupled to the memory 308, where the processor 306 includes suitable logic, circuitry, and/or interfaces that are operable to execute one or more instructions stored in the memory 308 to perform a predetermined operation. The memory 308 may be operable to store one or more instructions. The processor 306 may be implemented using the processors known in the art. Some of the commonly known memory implementations include, but are not limited to, a random access memory (RAM), a read only memory (ROM), a hard disk drive (HDD), and a secure digital (SD) card. Further, the memory 308 includes the one or more instructions that are executable by the processor 306 to perform specific operations. It is apparent to a person having ordinary skills in the art that the one or more instructions stored in the memory 308 enable the hardware of the controller 304 to perform the predetermined operations as explained above.

It should be obvious to a person skilled in the art that while drawing and some embodiments of this invention have been elaborated for a fixed number of channels, turns, and passes for the sake of simplicity and better explanation purpose, however, the teachings of this invention are equally applicable for any number of channels, turns, and passes based on the dimension and heat zones of the heat sink and/or the device, and all such embodiments are well within the scope of this invention.

Thus, this invention (refrigerant circuit and cooling system) overcomes the drawbacks, limitations, and shortcomings associated with existing technologies by enabling efficient distribution of the cooling fluid and achieving a high heat dissipation rate in high-power VFD and other devices while keeping the heat sink design compact and keeping the pressure drop low.

While the invention has been described with reference to exemplary embodiments, it will be understood by those skilled in the art that various changes may be made and equivalents may be substituted for elements thereof without departing from the scope of the invention as defined by the appended claims. Modifications may be made to adopt a particular situation or material to the teachings of the invention without departing from the scope thereof. Therefore, it is intended that the invention not be limited to the particular embodiment disclosed, but that the invention includes all embodiments falling within the scope of the invention as defined by the appended claims.

In interpreting the specification, all terms should be interpreted in the broadest possible manner consistent with the context. In particular, the terms "comprises" and "comprising" should be interpreted as referring to elements, components, or steps in a non-exclusive manner, indicating that the referenced elements, components, or steps may be present, or utilized, or combined with other elements, components, or steps that are not expressly referenced. Where the specification claims refer to at least one of something selected from the group consisting of A, B, C ....and N, the text should be interpreted as requiring only one element from the group, not A plus N, or B plus N, etc.

The following clauses recite aspects and features of the invention which may or may not be claimed, and which may provide basis for amendment(s) and one or more divisional applications.
1. A refrigerant circuit for a variable frequency drive (VFD) heat sink, the refrigerant circuit comprising:
   one or more channels machined in a predefined profile with one or more passes and positioned in thermal contact with one or more heat generating components associated with a VFD,
   wherein the channels are adapted to allow flow of a cooling fluid therethrough to facilitate dissipation of heat generated by the VFD.
2. The refrigerant circuit of clause 1, wherein the one or more channels extend over one or more heat dissipating zones of the heat sink, wherein the one or more heat dissipating zones are at an electronic and/or electrical mount area of the one or more heat generating components associated with the VFD.
3. The refrigerant circuit of clause 1, wherein the refrigeration circuit comprises:
   an inlet conduit fluidically connected to a first end of the one or more channels, wherein the inlet conduit is configured to receive and supply the cooling fluid to the one or more channels, such that the cooling fluid while flowing through the one or more channels absorbs the heat dissipated by the VFD, and
   an outlet conduit fluidically connected to a second end of the one or more channels, wherein the outlet conduit is configured to enable outflow of the heat-absorbed cooling fluid from the one or more channels.
4. The refrigerant circuit of clause 3, wherein the inlet conduit and the outlet conduit are configured parallelly at two opposite ends of the heat sink, wherein each of the channels having the predefined profile extends between the inlet conduit and the outlet conduit.
5. The refrigerant circuit of clause 4, wherein the inlet conduit and the outlet conduit are fluidically configured with a refrigerant line associated with a refrigeration system that enables controlled flow of the cooling fluid through the inlet conduit, the one or more channels, and the outlet conduit.
6. The refrigerant circuit of clause 5, wherein the VFD is associated with a compressor of the refrigeration system.
7. The refrigerant circuit of clause 1, wherein the one or more channels comprises a flow path having a predefined cross-sectional shape being machined in the predefined profile such that each of the machined channels comprises a predefined number of turns or a predefined number of passes.
8. A cooling system for a VFD, the cooling system comprising:
   a heat sink in thermal contact with one or more components of the VFD; and
   a refrigerant circuit machined in the heat sink such that the refrigerant circuit extends over and remains in thermal contact with the one or more components of the VFD;
   wherein the refrigerant circuit comprises one or more channels having a predefined profile and in thermal contact with the corresponding components of the VFD.
9. The cooling system of clause 8, wherein the refrigerant circuit comprises:
   an inlet conduit fluidically connected to a first end of the one or more channels of the refrigerant circuit, wherein the inlet conduit is configured to receive and supply the cooling fluid to the one or more channels, such that the cooling fluid while flowing through the one or more channels absorbs the heat dissipated by the VFD, and
   an outlet conduit fluidically connected to a second end of the one or more channels of the corresponding refrigerant circuit, wherein the outlet conduit is configured to enable outflow of the heat-absorbed cooling fluid from the one or more channels.
10. The cooling system of clause 9, wherein the inlet conduit and the outlet conduit associated with the refrigerant circuit are fluidically connected to a refrigerant line associated with a refrigeration system that is configured to enable controlled flow of the cooling fluid through the refrigerant circuit.
11. The cooling system of clause 8, wherein the cooling system comprises a controller in communication with the refrigeration system, wherein the controller is configured to:
   monitor temperature of the heat sink and/or the VFD; and
   enable the refrigeration system to facilitate a controlled flow of the cooling fluid through the refrigeration circuit of the heat sink to keep the heat sink or the VFD at a predefined temperature.
12. The cooling system of clause 8, wherein the one or more channels comprises a flowpath having a predefined cross-sectional shape being machined in the predefined profile such that each of the machined channels comprises a predefined number of turns or a predefined number of passes.
13. The cooling system of clause 8, wherein the one or more channels extend over one or more heat dissipating zones of the VFD, wherein the one or more heat dissipating zones are at an electronic and/or electrical mount area of the one or more components associated with the VFD.
14. A cooling system for a heat dissipating device, the cooling system comprising:
   a heat sink in thermal contact with one or more components of the device; and
   a refrigerant circuit machined in the heat sink such that the refrigerant circuit extends over and remains in thermal contact with the one or more components of the device,
   wherein the refrigerant circuit comprises one or more channels machined in a predefined profile and in thermal contact with the corresponding components of the device.
15. The cooling system of clause 14, wherein the refrigerant circuit comprises:
   an inlet conduit fluidically connected to a first end of the one or more channels of the refrigerant circuit, wherein the inlet conduit is configured to receive and supply the cooling fluid to the one or more channels, such that the cooling fluid while flowing through the one or more channels absorbs the heat dissipated by the device; and
   an outlet conduit fluidically connected to a second end of the one or more channels of the corresponding refrigerant circuit, wherein the outlet conduit is configured to enable outflow of the heat-absorbed cooling fluid from the one or more channels.
16. The cooling system of clause 15, wherein the inlet conduit and the outlet conduit of the refrigeration circuit are configured parallelly at two opposite ends of the corresponding heat sink, wherein each of the channels having the predefined profile extends between the two opposite ends of the heat sink.
17. The cooling system of clause 16, wherein the inlet conduit and the outlet conduit associated with the refrigerant circuit are fluidically configured with a refrigerant line associated with a refrigeration system that enables controlled flow of the cooling fluid through the refrigerant circuit.
18. The cooling system of clause 14, wherein the cooling system comprises a controller in communication with the refrigeration system, wherein the controller is configured to:
   monitor temperature of the heat sink and/or the device; and
   enable the refrigeration system to facilitate a controlled flow of the cooling fluid through the refrigeration circuit of the heat sink to keep the heat sink or the device at a predefined temperature.
19. The cooling system of clause 14, wherein the one or more channels comprise a flow path having a predefined cross-sectional shape being machined in the predefined profile such that each of the machined channels comprises a predefined number of turns or a predefined number of passes.
20. The cooling system of clause 14, wherein the device comprises one or more of a semiconductor device, a power-electronic device, an electrical circuit, and a printed circuit board.

## Claims

1. A refrigerant circuit for a variable frequency drive (VFD) heat sink, the refrigerant circuit comprising:
one or more channels machined in a predefined profile with one or more passes and positioned in thermal contact with one or more heat generating components associated with a VFD,
wherein the channels are adapted to allow flow of a cooling fluid therethrough to facilitate dissipation of heat generated by the VFD.

2. The refrigerant circuit of claim 1, wherein the one or more channels extend over one or more heat dissipating zones of the heat sink, wherein the one or more heat dissipating zones are at an electronic and/or electrical mount area of the one or more heat generating components associated with the VFD.

3. The refrigerant circuit of claim 1 or 2, wherein the refrigeration circuit comprises:
an inlet conduit fluidically connected to a first end of the one or more channels, wherein the inlet conduit is configured to receive and supply the cooling fluid to the one or more channels, such that the cooling fluid while flowing through the one or more channels absorbs the heat dissipated by the VFD, and
an outlet conduit fluidically connected to a second end of the one or more channels, wherein the outlet conduit is configured to enable outflow of the heat-absorbed cooling fluid from the one or more channels.

4. The refrigerant circuit of claim 3, wherein the inlet conduit and the outlet conduit are configured parallelly at two opposite ends of the heat sink, wherein each of the channels having the predefined profile extends between the inlet conduit and the outlet conduit.

5. The refrigerant circuit of claim 4, wherein the inlet conduit and the outlet conduit are fluidically configured with a refrigerant line associated with a refrigeration system that enables controlled flow of the cooling fluid through the inlet conduit, the one or more channels, and the outlet conduit.

6. The refrigerant circuit of any preceding claim, wherein the VFD is associated with a compressor of the refrigeration system.

7. The refrigerant circuit of any preceding claim, wherein the one or more channels comprises a flow path having a predefined cross-sectional shape being machined in the predefined profile such that each of the machined channels comprises a predefined number of turns or a predefined number of passes.

8. A cooling system for a heat dissipating device, the cooling system comprising:
a heat sink in thermal contact with one or more components of the device; and
a refrigerant circuit machined in the heat sink such that the refrigerant circuit extends over and remains in thermal contact with the one or more components of the device,
wherein the refrigerant circuit comprises one or more channels machined in a predefined profile and in thermal contact with the corresponding components of the device.

9. The cooling system of claim 8, wherein the refrigerant circuit comprises:
an inlet conduit fluidically connected to a first end of the one or more channels of the refrigerant circuit, wherein the inlet conduit is configured to receive and supply the cooling fluid to the one or more channels, such that the cooling fluid while flowing through the one or more channels absorbs the heat dissipated by the device; and
an outlet conduit fluidically connected to a second end of the one or more channels of the corresponding refrigerant circuit, wherein the outlet conduit is configured to enable outflow of the heat-absorbed cooling fluid from the one or more channels.

10. The cooling system of claim 9, wherein the inlet conduit and the outlet conduit of the refrigeration circuit are configured parallelly at two opposite ends of the corresponding heat sink, wherein each of the channels having the predefined profile extends between the two opposite ends of the heat sink.

11. The cooling system of claim 9 or 10, wherein the inlet conduit and the outlet conduit associated with the refrigerant circuit are fluidically configured with a refrigerant line associated with a refrigeration system that enables controlled flow of the cooling fluid through the refrigerant circuit.

12. The cooling system of any of claims 8 to 11, wherein the cooling system comprises a controller in communication with the refrigeration system, wherein the controller is configured to:
monitor temperature of the heat sink and/or the device; and
enable the refrigeration system to facilitate a controlled flow of the cooling fluid through the refrigeration circuit of the heat sink to keep the heat sink or the device at a predefined temperature.

13. The cooling system of any of claims 8 to 12, wherein the one or more channels comprise a flow path having a predefined cross-sectional shape being machined in the predefined profile such that each of the machined channels comprises a predefined number of turns or a predefined number of passes.

14. The cooling system of any of claims 8 to 13, wherein the device comprises one or more of a variable frequency drive (VFD), a semiconductor device, a power-electronic device, an electrical circuit, and a printed circuit board.

15. The cooling system of claims 8 to 13, wherein the device is a VFD, and wherein the one or more channels extend over one or more heat dissipating zones of the VFD, wherein the one or more heat dissipating zones are at an electronic and/or electrical mount area of the one or more components associated with the VFD.
